Europäisches Patentamt

**European Patent Office**

**Office européen des brevets**

(19)

(11) Publication number: **0 077 921**

**A2**

(12)

# EUROPEAN PATENT APPLICATION

(21) Application number: **82108706.1**

(22) Date of filing: **21.09.82**

(51) Int. Cl.³: **H 01 L 23/54**

(30) Priority: **23.10.81 JP 169901/81**

(43) Date of publication of application:
**04.05.83 Bulletin 83/18**

(84) Designated Contracting States:
**DE GB IT**

(71) Applicant: **TOKYO SHIBAURA DENKI KABUSHIKI KAISHA**
**72, Horikawa-cho Saiwai-ku**
**Kawasaki-shi Kanagawa-ken 210(JP)**

(72) Inventor: **Komatsu, Shigeru**
**209 Kamakura-Green-mansion 436-1, Ueki**
**Kamakura-shi Kanagawa-ken(JP)**

(72) Inventor: **Fujita, Katsuji**
**36-7, Torigaoka Totsuka-ku**
**Yokohama-shi(JP)**

(74) Representative: **Lehn, Werner, Dipl.-Ing. et al,**
**Hoffmann, Eitle & Partner Patentanwälte**
**Arabellastrasse 4 (Sternhaus)**
**D-8000 München 81(DE)**

(54) **Semiconductor device.**

(57) An emitter region (15) of a first conductivity type (n⁺) and base connecting region (16) of the first conductivity type constituting a base current path are formed in the base region (14) of a second conductivity type of a bipolar transistor. A collector connecting region (17) of the first conductivity type is formed in the collector region (12) of the bipolar transistor. Further, an emitter electrode (19), base electrode (20) and collector electrode (21) respectively making an ohmic contact with the collector region, base connecting region and collector connecting region through the corresponding contact holes provided through an insulation layer (18).

F I G. 2B

- 1 -

## Semiconductor device

This invention relates to a semiconductor device, and more particularly to a semiconductor device adapted to be applied as a bipolar monitor transistor whose emitter region is formed by diffusing an impurity included in a polycrystalline silicon layer which is used as an impurity source.

A bipolar semiconductor device is manufactured by the diffusion of an impurity first in the base region and then in the emitter region. In this case it is necessary to establish the condition of the emitter diffusion in order to let the current amplification rate $\beta$ of the bipolar transistor have a prescribed value. For this purpose, a preceding test is made of the impurity diffusion in the emitter region of at least one bipolar transistor corresponding to that lot of transistors whose base has been formed by the diffusion of an impurity, thereby determining the precise condition of the emitter diffusion in the lot of transistors. The emitter diffusion of the aforementioned lot of transistors is effected in accordance with the conditions of diffusion thus determined. In other words, determination is made of the $\beta$ value of a bipolar transistor whose emitter region has been formed by the preceding diffusion of an impurity and the withstand voltage between the respective junctions. The condition of the emitter diffusion of the aforementioned lot of transistors is decided from the result of the determination. Hereinafter, a transistor applied for the above-mentioned object is referred to as "a monitor transistor". Hitherto, this monitor transistor has been formed in an extremely larger size than the actual bipolar transistors included in the aforementioned lot. The reason why the monitor transistor must have such a large size is that it is desired to quickly determine the characteristics of the monitor transistor by omitting the deposition of an electrode on the emitter, base and collector regions, removing an insulation layer used as a mask for the emitter diffusion from the semiconductor layer and contacting probes to the emitter, base and collector regions. However, it sometimes happens that the characteristics of a monitor transistor having a large size do not accord with those of bipolar transistors formed as actual circuit elements. Further, when the monitor transistor has shallow junctions, the method of determining the characteristics of the monitor transistor by attaching a probe to the diffused regions is accompanied with the draw backs that different determination values result depending on the magnitude of the force with which a needle is pressed. Consequently the conventional monitor transistor has failed to precisely monitor impurity diffusion.

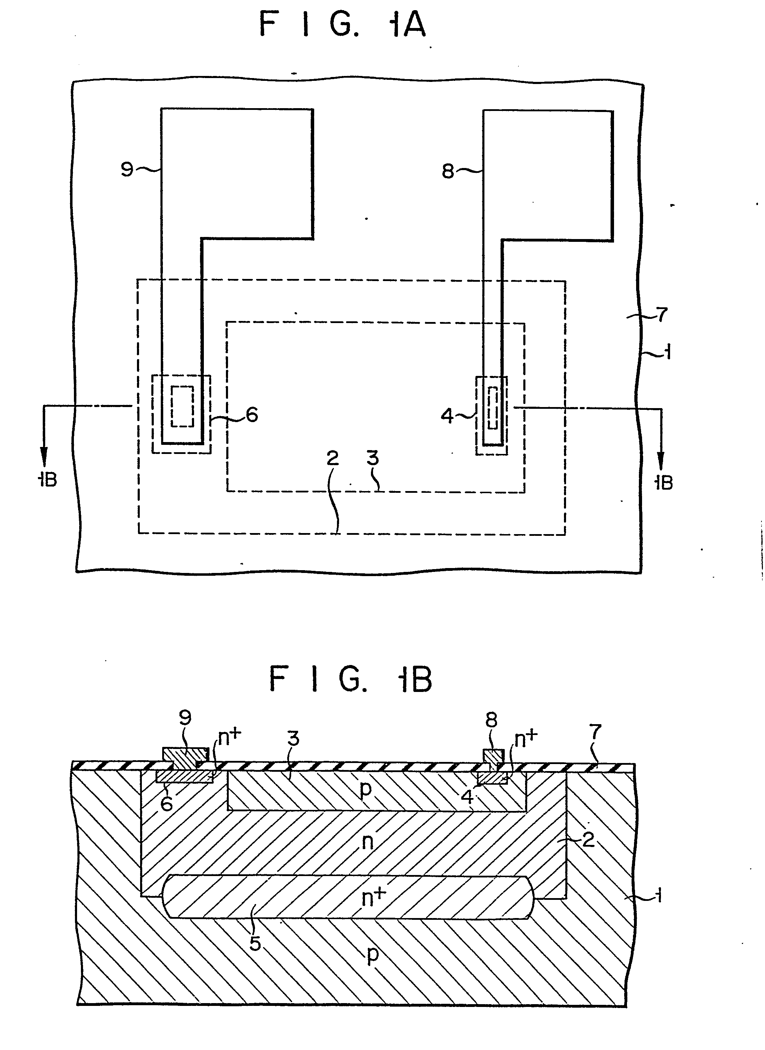

To eliminate the above-mentioned drawbacks, the present inventors previously proposed a preceding diffusion-monitoring transistor shown in Figs. 1A and 1B (the Japanese patent disclosure 54-145,481). Referring to Figs. 1A and 1B, an n-type collector region 2 is formed in a p-type silicon substrate 1. A p-type base region 3 is formed in the collector region 2. An $n^+$-type embedded layer 5 is formed in an interface between the collector region 2 and substrate 1. An $n^+$-type collector-connecting region 6 constituting a collector current path is formed in the collector region 2. An emitter electrode 8 making an ohmic contact with the emitter region 4 and a collector electrode 9 making an ohmic contact with the collector connecting region 6 are formed through contact holes provided through a silicon oxide layer 7 mounted on the substrate 1. The emitter electrode 8 and collector electrode 9 include an n-type impurity such as phosphorus or arsenic and are formed of a polycrystalline silicon layer used as a source of impurity diffusion for the emitter region 4 and collector connecting region 6. Both electrodes 8 and 9 are patterned with a sufficiently large size to allow for probing.

The monitor transistor shown in Figs. 1A and 1B has the advantage that it is possible to test the transistor by attaching a probe to the emitter electrode 8 and collector electrode 9 used as a source of preceding diffusion, thereby eliminating the errors of measurement which might arise from variations in the needle pressures; and the emitter region 4 can have the same area as the emitter area of an actual transistor, thereby elevating the monitoring precision of a monitor transistor. When, however, the characteristic of the monitor transistor is measured, it is necessary to remove the oxide layer 7 and attach a probe to the base region 3. To this end, the base region must have considerably larger dimensions than the base region of an actual transistor. The base region 3 has the opposite conductivity to the emitter region 4 and collector region 2. Therefore, it has been considered impossible to provide an $n^+$ region on the base region 3 and also a probing electrode ohmically contacting the $n^+$ region. When, therefore, a probing electrode is fitted to the emitter region 4, collector region 2 and base region 3, then it is necessary to adapt the ordinary step of manufacturing a bipolar transistor, that is, providing a contact hole to the insulation layer 7, depositing an electrode material and patterning the deposited electrode material layer. If a monitor transistor must be manufactured through the above complicated steps, then it is impossible to let a monitor transistor fulfil the monitoring diffusion easily and quickly.

It is accordingly the object of this invention to provide a semiconductor device which can be easily formed with the same dimensions as an actual bipolar transistor and is adapted to be applied as a bipolar monitor transistor for quickly monitoring emitter diffusion without being affected by variations in the needle pressure.

To attain the above-mentioned object, this invention provides a semiconductor device which comprises: a collector region of a first conductivity type; a base region of a second conductivity type formed in part of the collector region; at least one emitter region of the first conductivity type formed in part of the base region; at least one base connecting region of the first conductivity type which is formed in the other part of the base region to constitute a base current path; at least one collector connecting region of the first conductivity type which is formed in the other part of the collector region to constitute a collector current path; an insulating layer which is mounted on the surface of the collector region and provided with contact holes respectively facing the emitter region, base connecting region and collector connecting region; and an emitter electrode, base electrode and collector electrode respectively making an ohmic contact with the emitter region, base connecting region and collector connecting region.

This invention can be more fully understood from the following detailed description when taken in conjunction with the accompanying drawings, in which:

Fig. 1A is a plan view of the conventional bipolar monitor transistor;

Fig. lB is a sectional view on line lB - lB of Fig. lA;

Fig. 2A is a plan view of a bipolar monitor transistor embodying this invention;

Fig. 2B is a sectional view on line 2B - 2B of Fig. 2A; and

Fig. 3 is an equivalent circuit diagram of the bipolar monitor transistor of Figs. 2A and 2B.

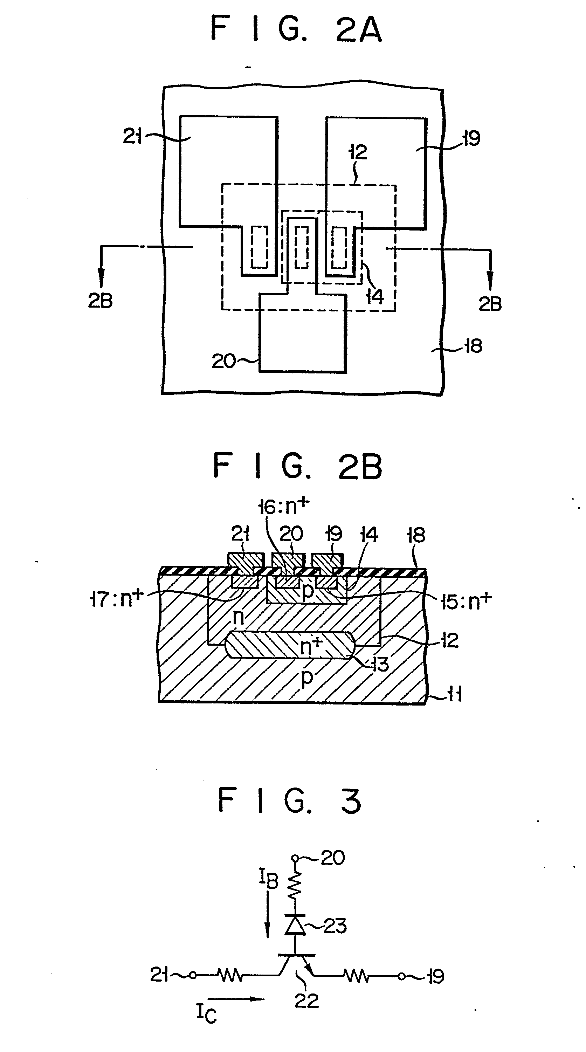

Referring to Figs. 2A and 2B, an n-type collector region 12 is formed in a p-type silicon substrate 11. A p-type base region 14 is formed in the n-type collector region 12. An $n^+$-type layer 13 is embedded in an interface region between the collector region 12 and semiconductor substrate 11 to reduce collector resistance. Formed in the p-type base region 14 are an $n^+$-type emitter region 15 and $n^+$-type base connecting region 16 constituting a base current path. An $n^+$-type collector connecting region 17 constituting a collector current path is formed in the n-type collector region 12.

On the surface of the p-type silicon substrate 11 is formed an insulating layer 18 provided with contact holes respectively facing the emitter region 15, base connecting region 16 and collector connecting region 17. Mounted on the insulation layer 18 are an emitter electrode 19 making an ohmic contact with the emitter region 15 through a corresponding contact hole, a base electrode 20 making an ohmic contact with the base connecting region 16, and an collector electrode 21 making an ohmic contact with the collector connecting region 17. The emitter electrode 19, base electrode 20 and collector electrode 21 are formed by patterning a polycrystalline silicon layer which contains an n-type impurity such as phosphorus or arsenic and is used as a source of diffusion for providing the emitter region 15, base connecting region 16 and collector connecting region 17. These electrodes 19, 20 and 21 are respectively provided with a probing region. The emitter region 15, collector connecting region 17, base region 14 and collector region 12 are formed with the same area as an actual bipolar transistor. The bipolar monitor transistor of this invention is different from an actual bipolar transistor only in that the subject bipolar monitor transistor comprises the base connecting region 16.

Description is now given of the method of manufacturing a bipolar monitor transistor of Figs. 2A and 2B embodying this invention. The insulation layer 18 is deposited on the surface of the substrate 11, on which the collector region 12 and base region 14 are previously formed. Contact holes are formed through the prescribed portions of the insulation layer 18. Later, a polycrystalline silicon layer containing an n-type impurity is formed on the insulation layer 18. The electrodes 19 to 21 are formed by patterning the polycrystalline silicon layer. The bipolar monitor transistor of the invention is later finished only by carrying out impurity diffusion to form the emitter region 15, base connecting region 16 and collector connecting region 17.

Description is now given of the method of testing the bipolar monitor transistor of Figs. 2A and 2B. The p-type base region 14 and $n^+$-type base connecting region 16 jointly constitute a diode 23 by means of a p-n junction. Therefore, the arrangement of this bipolar monitor transistor can be illustrated by the equivalent circuit diagram of Fig. 3. In other words, the subject bipolar monitor transistor is equivalent to a transistor which is constructed by connecting the probing electrode 20 to the base of the ordinary bipolar transistor 22 consisting of the n-type collector region 12, p-type base region 14 and $n^+$-type emitter region 15, with the aforesaid diode 23 interposed between the probing electrode 20 and the base of the ordinary bipolar transistor 22 in the state of reversed polarity. When excess voltage happens to be impressed on the electrode 20 to give rise to the breakdown of the diode 23, then base current $I_B$ runs in the indicated direction, and a collector current $I_C$ corresponding to the base current $I_B$ flows in the indicated direction.  In other words, under the condition in which a higher voltage than the breakdown voltage of the diode 23 is impressed on the base electrode 20, the subject bipolar monitor transistor of Figs. 2A, 2B is operated in the same manner as the ordinary bipolar transistor, thereby allowing for the measurement of the current amplification rate $\beta$. Therefore, by carring out an impurity diffusion to the emitter of the monitor transistor, it is possible to define the condition of the emitter diffusion of the transistors of that lot to which said monitor transistor belongs.

As seen from the aforementioned method of manufacturing a bipolar monitor transistor embodying this invention, the monitor transistor has the advantages that it can be manufactured without taking the complicated steps as in the case with the conventional monitor transistor; the desired characteristics can be determined without being affected by the needle pressure after the emitter diffusion is carried out; the semiconductor regions of the monitor transistor can have the same area as those of an actual transistor; and a silicon wafer is not contaminated because it is unnecessary to remove an insulation layer.

As shown in Fig. 2B, the base connecting region 16 is provided, thereby causing the $n^+$-type emitter region 15, p-type base region 14 and $n^+$-type base connecting region 16 to jointly constitute a parasitic transistor. However, the correct $\beta$ value of the bipolar monitor transistor of this invention proves that since the bipolar transistor comprising shallow p-n junctions contain high concentrations of impurities, the characteristics of the subject bipolar monitor transistor are not substantially changed by the parasitic transistor.

The semiconductor device of this invention is not limited to a diffusion_type monitor transistor alone. But it will be noted that a semiconductor device whose arrangement is illustrated by the equivalent circuit of Fig. 3 is also included in the scope claimed by the invention. With the semiconductor device whose arrangement is schematically shown by the equivalent circuit of Fig. 3, the diode 23 can be formed in an area occupied by the ordinary bipolar transistor 22. Therefore, the subject semiconductor device can be manufactured with substantially two-fold integration density as compared with the case where the transistor 22 and diode 23 are separately provided.

Claims:

1.   A semiconductor device which comprises:

a collector region (12) of a first conductivity type (n);

a base region (14) of a second conductivity type (p) formed in part of said collector region;

at least one emitter region (15) of said first conductivity type (n) formed in part of said base region;

at least one collector connecting region (17) of said first conductivity type which is formed in the other part of the collector region to constitute a collector current path;

an insulation layer (18) which is mounted on the surface of the collector region and provided with contact holes respectively facing said emitter region, and said collector connecting region; and

an emitter electrode (19) and collector electrode (21) respectively making an ohmic contact with said emitter region and collector connecting region through the corresponding contact hole; characterized in that said semiconductor device further comprises at least one base connecting region (16) of said first conductivity type formed in said base region (14) and a base electrode (20) making an ohmic contact with said base connecting region through a corresponding contact hole provided through said insulation layer (18).

2.   The semiconductor device according to claim 1, characterized in that said emitter electrode (19), base electrode (20) and collector electrode (21) are prepared from a polycrystalline silicon layer of said first conductivity type applied as a source of impurity diffusion for providing said emitter region, base connecting region and collector connecting region, and are respectively patterned in a probing size.

# F I G. 1A

# F I G. 1B

# F I G. 2A

# F I G. 2B

# F I G. 3